# EUROPEAN PATENT APPLICATION

(11) **EP 2 508 759 A2**
(43) Date of publication of application: **10.10.2012**
(21) Application number: 11006523.2
(22) Date of filing: 09.08.2011
(51) Int. Cl.: F04D 17/04, F04D 25/06

(54) **Cooling system equipped with an advection-type fan**

(30) Priority: 08.04.2011 TW 100112256
(71) Applicant: Sunonwealth Electric Machine Industry Co., Ltd., Kaohsiung, Taiwan R.O.C. (TW)
(72) Inventor: Zheng, Yuan-Jie, Kaohsiung (TW); Horng, Alex, Kaohsiung (TW); Lee, Chen-Hsueh, Kaohsiung (TW)
(74) Representative: Köhler, Walter

(57) **Abstract**

A cooling system equipped with an advection-type fan is disclosed. The cooling system includes a casing (1, 3) and an advection-type fan (2, 4). The casing (1, 3) has a compartment (11, 31). The cooling system is characterized in that the compartment (11, 31) of the casing (1, 3) receives a heat-emitting source (111, 311) or a heat-conducting element (112). The casing (1, 3) further comprises at least one radial air-guiding opening (12, 32) communicating with the compartment (11, 31). The advection-type fan (2, 4) has a frame (21, 41) disposed in the compartment (11, 31). The frame (21, 41) has an air-guiding lateral wall (211, 411) defining a radial air channel (212, 412). The frame (21, 41) has a radial air inlet (213, 413) and a radial air outlet (214, 414), both the radial air inlet (213, 413) and the radial air outlet (214, 414) communicate with the radial air channel (212, 412). The radial air channel (212, 412) receives an impeller (22, 42) that causes air advection to dissipate the heat of the heat-emitting source (111, 311) or the heat-conducting element (112). The frame (21, 41) has two sides in an axial direction of the impeller (22, 42) that are completely laid open.

## Description

### BACKGROUND OF THE INVENTION

### 1. Field of the Invention

The present invention generally relates to a cooling system and, more particularly, to a cooling system equipped with an advection-type fan.

### 2. Description of the Related Art

Conventional cooling fans are mainly categorized into two types: axial-flow type and blower type. The axial-flow type cooling fan has an axial air inlet and an axial air outlet opposite to the axial air inlet. The air can be drawn via the axial air inlet and then expelled via the axial air outlet. The blower type cooling fan has an axial air inlet in the axial direction, as well as a radial air outlet in the radial direction thereof. Thus, the air can be drawn via the axial air inlet and then expelled via the radial air outlet for cooling operation.

However, the axial-flow type cooling fan must be mounted on a top of an electronic device to be cooled, such as on the top of a Central Processing Unit (CPU) of a computer. This is because the axial-flow type cooling fan can only expel air in the axial direction rather than the radial direction. Therefore, the axial height of the electronic device can not be reduced. In addition, since the blower type cooling fan draws air via the axial air inlet (in an axial direction) and expels air via the radial air outlet (in a radial direction), the blower type cooling fan can not be applied to electronic devices that draw air from a lateral face (from the radial direction), such as a handset or a Personal Digital Assistant (PDA).

In light of the problems, a conventional advection-type fan capable of drawing and expelling air in the radial direction was proposed. Referring to Fig. 1, a conventional advection-type fan 8 is disclosed by a Taiwanese Patent No. 553323 entitled "Fan Structure Having Horizontal Convection". The conventional advection-type fan 8 includes a housing 81 and an impeller 82. The housing 81 is a hollow housing consisting of a bottom plate 811, a plurality of lateral walls 812 and a cover plate 813. The housing 81 includes at least one radial air inlet 83 and at least one radial air outlet 84. The impeller 82 is disposed in the housing 81. Based on this, the conventional advection-type fan 8 can be installed in a casing 9 of an electronic device. When the impeller 82 rotates, the at least one radial air inlet 83 and the at least one radial air outlet 84 can cause air advection, bringing air into the casing 9 to cool down a heat-emitting source (i.e. an electronic component) therein.

When the conventional advection-type fan 8 is installed in the casing 9, however, the casing 9 should have an enough inner space for accommodation of the conventional advection-type fan 8. The inner space should be in a predetermined height equal to or larger than a sum total height of the bottom plate 811, lateral walls 812 and cover plate 813. Note the thickness of the casing 9 should also be considered. Thus, the casing 9 will have a height (H) that is the thickness of the casing 9 plus the sum total height of the bottom plate 811, lateral walls 812 and cover plate 813, all included. This leads to a thick casing 9 and the overall volume of the casing 9 can not be reduced.

### SUMMARY OF THE INVENTION

It is therefore the primary objective of this invention to provide a cooling system equipped with an advection-type fan, in which the cooling system is allowed to have a smaller volume when the advection-type fan is installed therein.

The invention discloses a cooling system equipped with an advection-type fan. The cooling system includes a casing and an advection-type fan. The casing has a compartment. The cooling system is characterized in that the compartment of the casing receives a heat-emitting source or a heat-conducting element. The casing further comprises at least one radial air-guiding opening communicating with the compartment. The advection-type fan has a frame disposed in the compartment. The frame has an air-guiding lateral wall defining a radial air channel. The frame has a radial air inlet and a radial air outlet, and both the radial air inlet and the radial air outlet communicate with the radial air channel. The radial air channel receives an impeller that causes air advection to dissipate the heat of the heat-emitting source or the heat-conducting element. The frame has two sides in an axial direction of the impeller that are completely laid open.

Furthermore, the invention discloses a cooling system equipped with an advection-type fan. The cooling system includes a casing and an advection-type fan. The casing has a compartment receiving a heat-emitting source or a heat-conducting element. The casing further comprises a radial air-guiding opening communicating with the compartment. The compartment forms a radial air channel communicating with the radial air-guiding opening. The advection-type fan has a base disposed in the radial air channel and coupled with an impeller. The impeller causes air advection to dissipate the heat of the heat-emitting source or the heat-conducting element.

### BRIEF DESCRIPTION OF THE DRAWINGS

The present invention will become more fully understood from the detailed description given hereinafter and the accompanying drawings which are given by way of illustration only, and thus are not limitative of the present invention, and wherein:
Fig. 1 shows a diagram of a cooling system equipped with a conventional advection-type fan.
Fig. 2 shows an exploded diagram of a cooling system equipped with an advection-type fan according to a first embodiment of the invention.
Fig. 3 shows a top cross-sectional diagram of the cooling system of the first embodiment of the invention.
Fig. 4 shows an exploded diagram of the advection-type fan of the first embodiment of the invention.
Fig. 5 shows a side cross-sectional diagram of the cooling system of the first embodiment observed at line 5-5 in Fig. 3.
Fig. 6 shows an exploded diagram of a cooling system equipped with an advection-type fan according to a second embodiment of the invention.
Fig. 7 shows an exploded diagram of a cooling system equipped with an advection-type fan according to a third embodiment of the invention.

In the various figures of the drawings, the same numerals designate the same or similar parts. Furthermore, when the term "first", "second", "third", "fourth", "inner", "outer" "top", "bottom" and similar terms are used hereinafter, it should be understood that these terms refer only to the structure shown in the drawings as it would appear to a person viewing the drawings, and are utilized only to facilitate describing the invention.

### DETAILED DESCRIPTION OF THE INVENTION

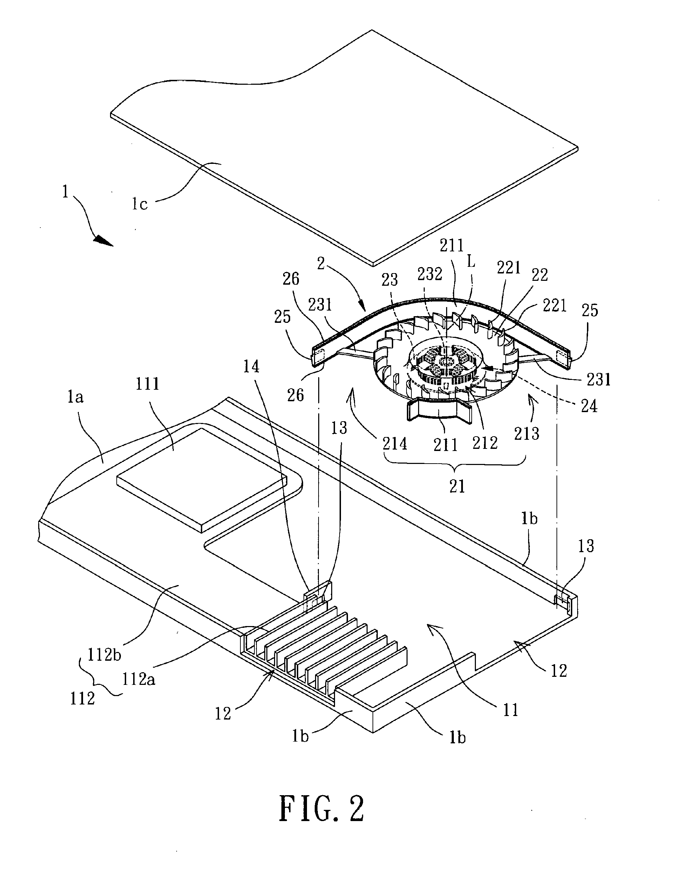

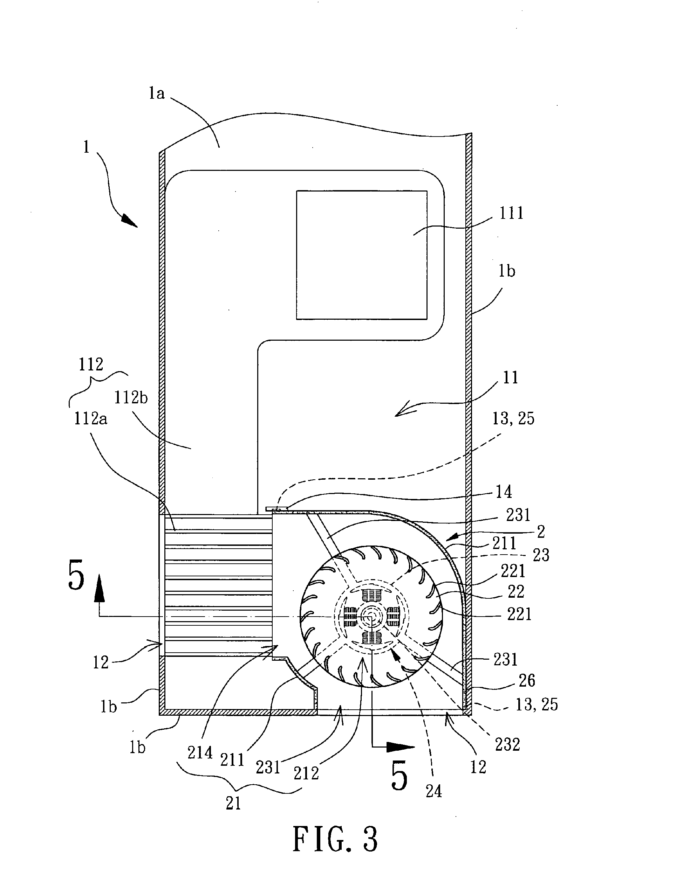

Referring to Figs. 2 and 3, a cooling system equipped with an advection-type fan comprises a casing 1 and an advection-type fan 2 according to a first embodiment of the invention. The casing 1 may be a housing of an electronic device that generates heat during operation thereof, such as a Personal Digital Assistant (PDA), mobile phone, computer or others. The advection-type fan 2 is disposed in the casing 1 to provide a predetermined cooling function.

The casing 1 comprises a compartment 11 having one or both of a heat-emitting source 111 and a heat-conducting element 112. For instance, the compartment 11 may only have the heat-emitting source 111. Thus, the advection-type fan 2 can operate to dissipate the heat of the heat-emitting source 111. Alternatively, the compartment 11 may have both the heat-emitting source 111 and the heat-conducting element 112. At this point, the advection-type fan 2 can operate to dissipate the heat of the heat-emitting source 111 via the heat-conducting element 112. The casing 1 further comprises two radial air-guiding openings 12 communicating with the compartment 11, with at least one fixing portion 13 arranged therebetween. The at least one fixing portion 13 can be of any structure on which the advection-type fan 2 is fixed. For example, the at least one fixing portion 13 can be of a structure that allows the advection-type fan 2 to be fixed thereon by ways of fastening, screwing, soldering or adhesion.

In this embodiment, the casing 1 further comprises a bottom plate 1a having a plurality of side walls 1b on a periphery thereof, with the side walls 1b connected to a cover plate 1c facing the bottom plate 1a. As such, the bottom plate 1a, side walls 1b and cover plate 1c may jointly form the casing 1. The two radial air-guiding openings 12 are arranged on two adjacent side walls 1b of the casing 1. The compartment 11 has both the heat-emitting source 111 and the heat-conducting element 112. The heat-conducting element 112 consists of a cooling fin module 112a and a cooling plate 112b, with the cooling fin module 112a disposed at one radial air-guiding opening 12. The cooling plate 112b has one end connected to the cooling fin module 112a and the other end connected to the heat-emitting source 111. The at least one fixing portion 13 of the casing 1 is implemented as two engaging grooves. One engaging groove is arranged on an inner wall of one side wall 1b and the other engaging groove is arranged on a face of a fixing board 14 disposed in the compartment 11.

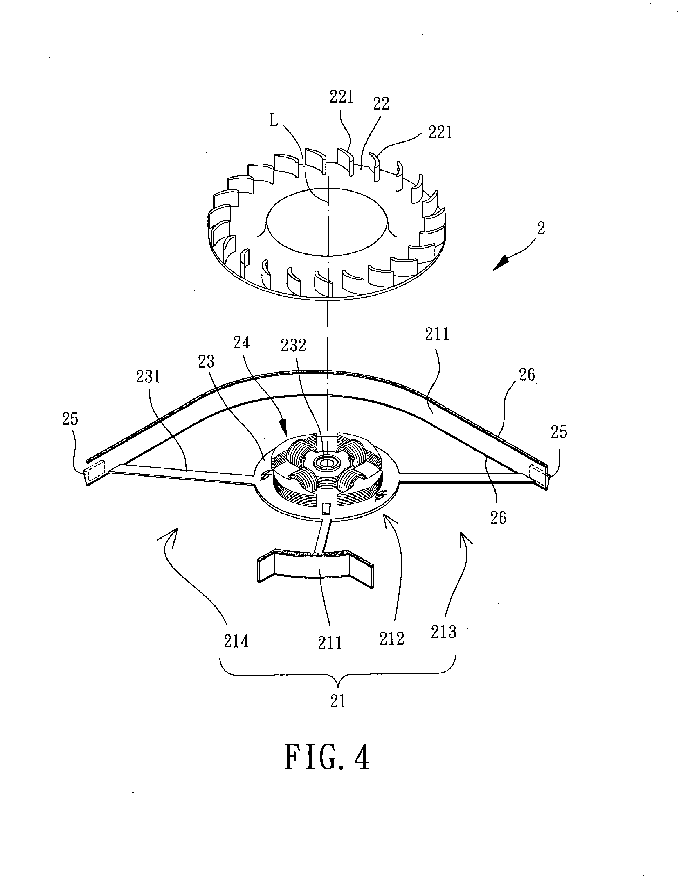

The advection-type fan 2 comprises a frame 21 disposed in the compartment 11 and fixed on the at least one fixing portion 13. Referring to Fig. 4, the frame 21 has an air-guiding lateral wall 211 that defines a radial air channel 212. The air-guiding lateral wall 211 has a radial air inlet 213 and a radial air outlet 214, with both the radial air inlet 213 and the radial air outlet 214 communicating with the radial air channel 212. The radial air inlet 213 and the radial air outlet 214 face the two radial air-guiding openings 12 of the casing 1, respectively. An impeller 22 may be rotatably disposed in the radial air channel 212. Referring to Fig. 4, the impeller 22 may have a plurality of vanes 221 that can drive the air to cause air advection. The frame 21 has two sides in an axial direction L that are completely laid open.

In this embodiment, the frame 21 of the advection-type fan 2 has a base 23 disposed therein. The base 23 is connected to the air-guiding lateral wall 211 via a plurality of connection members 231. Further, the base 23 has a shaft-coupling portion 232 to which the impeller 22 is rotatably connected. The base 23 has a driving unit 24 that can drive the impeller 22 to rotate. The driving unit 24 may consist of components such as a coil, a circuit board and so on. One skilled in this art may readily appreciate that the driving unit 24 drives the impeller 22 to rotate based on alternating magnetic fields (which are generated under a permanent magnet of the impeller 22), so it is not described herein again. The air-guiding lateral wall 211 of the frame 21 has two engaged protrusions 25. When the at least one fixing portion 13 is implemented as two engaging grooves, the engaged protrusions 25 can be engaged in the engaging grooves respectively. This allows the advection-type fan 2 to be securely coupled in the compartment 11 of the casing 1 and provides easy assembly and disassembly of the advection-type fan 2.

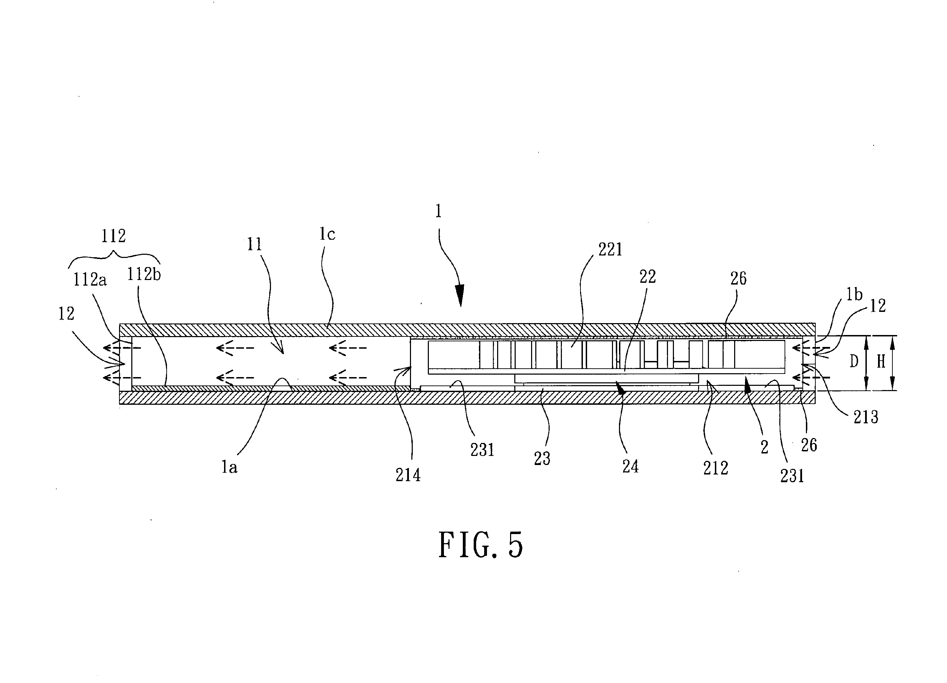

Referring to Fig. 5, the bottom plate 1a is spaced from the cover plate 1c by a distance (D), and the air-guiding lateral wall 211 of the advection-type fan 2 has an axial height (H) in the axial direction L of the impeller 22. The axial height (H) of the advection-type fan 2 is preferably equal to the distance (D) such that no gap is presented between the air-guiding lateral wall 211 and the bottom plate 1a and cover plate 1c. Thus, when the advection-type fan 2 drives the air to flow in the radial air channel 212, the air can be prevented from escaping from the radial air channel 212 via such gap. To prevent any potential gap from forming between the air-guiding lateral wall 211 and the bottom plate 1a and cover plate 1c for better airtightness, a sealing element 26 such as a silicon gel or rubber can be disposed between the air-guiding lateral wall 211 and the bottom plate 1a, and between the air-guiding lateral wall 211 and the cover plate 1c. The sealing element 26 can be disposed at one side of the air-guiding lateral wall 211 that faces the bottom plate 1a or the cover plate 1c, or disposed at both sides of the air-guiding lateral wall 211 that face the bottom plate 1a and the cover plate 1c. Thus, easy assembly of the advection-type fan 2 is attained.

Specifically, the bottom plate 1a and the cover plate 1c are used to close the compartment 11 of the casing 1 so that the radial air channel 212 can only be accessed via the two radial air-guiding openings 12. Thus, the bottom plate 1a and the cover plate 1c are preferably disposed in the axial direction L of the impeller 22 so as to cover the rotation range of the impeller 22. Alternatively, there can only be the cover plate 1c disposed over the impeller 22 to cover the rotation range of the impeller 22. In this way, the cover plate 1c can close the radial air channel 212 in the axial direction L of the impeller 22.

When the cooling system of the invention is in use, the driving unit 24 of the advection-type fan 2 can drive the impeller 22 to rotate once the heat-emitting source 111 (which is an electronic component in the electronic device) is overheated during operation of the electronic device. Therefore, the impeller 22 will draw air into the radial air channel 212 via one radial air-guiding opening 12 and the radial air inlet 213, and then expels air from the radial air channel 212 via the other radial air-guiding opening 12 and the radial air outlet 214. The driven air can dissipate the heat of the heat-conducting element 112 generated by and delivered from the heat-emitting source 111, ensuring the normal operation of the cooling system equipped with the advection-type fan 2. Thus, longer service life of the cooling system is achieved.

Based on the structural features disclosed previously, the cooling system of the invention is characterized as follows.

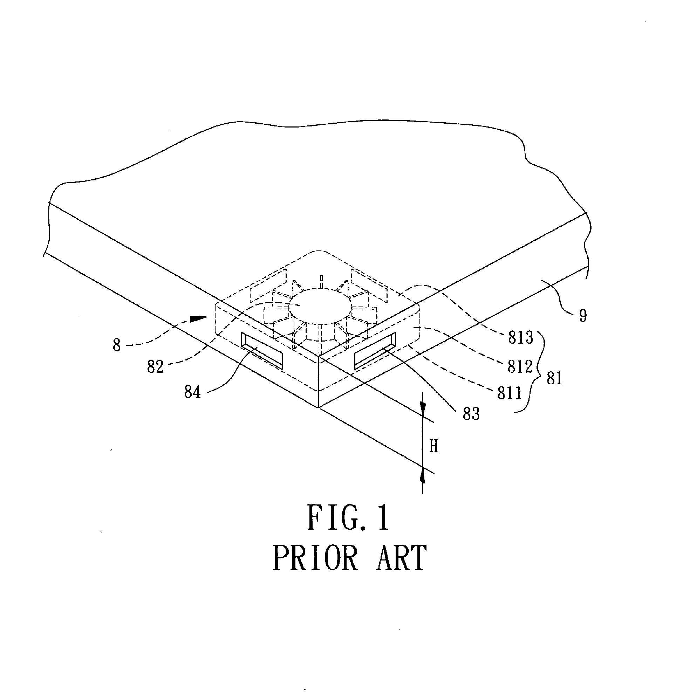

First, the overall height of the casing 1 can be reduced. This is because that the frame 21 of the advection-type fan 2 merely consists of the air-guiding lateral wall 211, and two sides of the advection-type fan 2 in the axial direction L are completely laid open. In such an arrangement, the advection-type fan 2 does not need to arrange the bottom plate 811 and the cover plate 813 on two sides thereof as required by the conventional housing 81 (Fig. 1). As an advantage, the height of the compartment 11 can be designed in a smaller value fitted to the axial height (H) of the air-guiding lateral wall 211.

Second, the radial air channel 212 of the frame 21 may form a channel structure in the compartment 11 of the casing 1 by simply disposing the advection-type fan 2 in the compartment 11 of the casing 1. Based on this, the casing 1 does not need to form a channel structure itself, thereby achieving convenient manufacturing and assembly of the casing 1 and reducing the structural complexity of the casing 1.

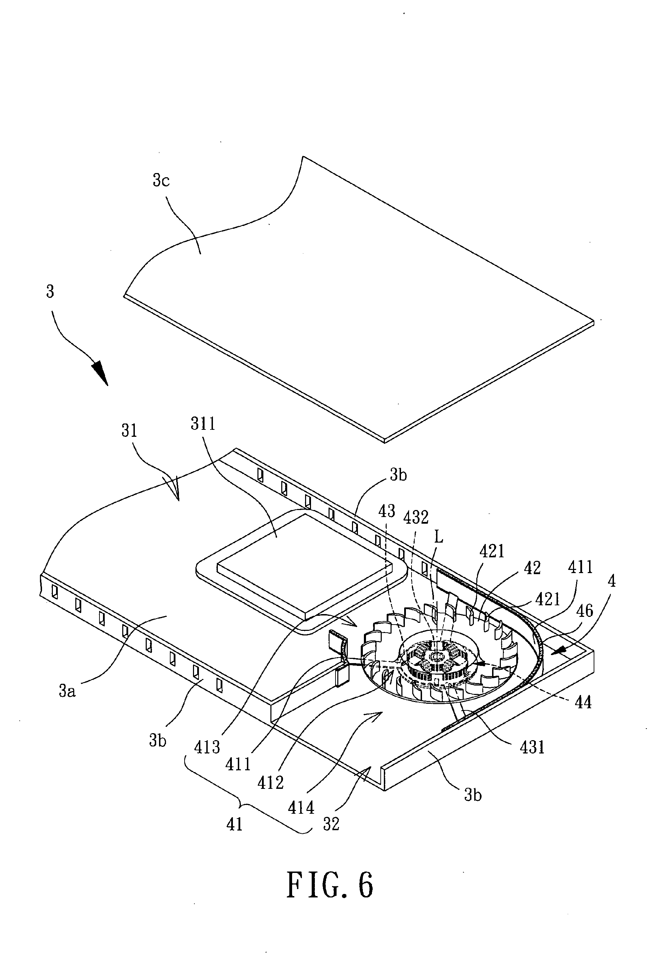

Referring to Fig. 6, a cooling system equipped with an advection-type fan also includes a casing 3 and an advection-type fan 4 according to a second embodiment of the invention. The advection-type fan 4 is disposed in the casing 3.

The casing 3 of the second embodiment also comprises a bottom plate 3a, a plurality of side walls 3b and a cover plate 3c, with the bottom plate 3a, side walls 3b and cover plate 3c jointly forming a compartment 31. The compartment 31 only has a heat-emitting source 311. The casing 3 has one radial air-guiding opening 32 on one side wall 3b thereof, with the radial air-guiding opening 32 communicating with the compartment 31.

Similar to the advection-type fan 2 in the first embodiment, the advection-type fan 4 in this embodiment also comprises a frame 41, an air-guiding lateral wall 411, a radial air channel 412, a radial air inlet 413, a radial air outlet 414, an impeller 42, a plurality of vanes 421, a base 43, a plurality of connection members 431, a shaft-coupling portion 432, a driving unit 44 and a sealing element 46. The frame 41 in this embodiment is coupled with the casing 3 by way of adhesion and thus, the advection-type fan 4 does not need the engaged protrusions 25 anymore. The advection-type fan 4 has similar structure to the advection-type fan 2, so it is not described herein again although it has a slightly different shape from the advection-type fan 2.

The cooling system equipped with the advection-type fan 4 (the second embodiment) differs from that equipped with the advection-type fan 2 (the first embodiment) in that the casing 3 only has one radial air-guiding opening 32. Thus, one of the radial air inlet 413 and the radial air outlet 414 will face the heat-emitting source 311 while the other one faces the radial air-guiding opening 32. In particular, the radial air outlet 414 will face the radial air-guiding opening 32 when the radial air inlet 413 faces the heat-emitting source 311 or, alternatively, the radial air inlet 413 will face the radial air-guiding opening 32 when the radial air outlet 414 faces the heat-emitting source 311, depending on the rotation direction of the impeller 42 (clockwise or counterclockwise direction).

Referring to Fig. 6, the casing 3 is a hollow casing having an inner space not completely closed. For example, the casing 3 may have a plurality of vents for ventilation. Thus, when the heat-emitting source 311 is overheated during operation of the electronic device, the impeller 42 of the advection-type fan 4 can draw the heat of the heat-emitting source 311 into the radial air channel 412 via the radial air inlet 413, then expels the heat from the radial air channel 412 via the radial air outlet 414. Furthermore, the cooling system of the second embodiment also allows the casing 3 to have a smaller thickness, thereby reducing the volume of the casing 3. Thus, the convenient manufacturing and assembly of the casing 3 are achieved and the structural complexity of the casing 3 is simplified.

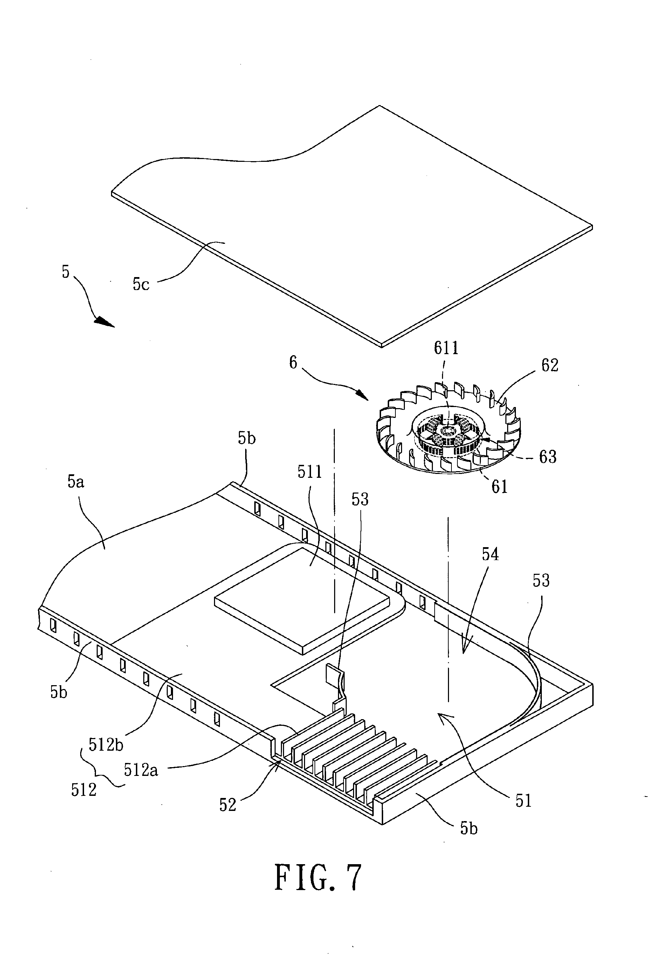

Referring to Fig. 7, a cooling system equipped with an advection-type fan also includes a casing 5 and an advection-type fan 6 according to a third embodiment of the invention. The advection-type fan 6 is disposed in the casing 5.

The casing 5 of the third embodiment also comprises a bottom plate 5a, a plurality of side walls 5b and a cover plate 5c, with the bottom plate 5a, side walls 5b and cover plate 5c jointly forming a compartment 51. The compartment 51 has a heat-emitting source 511 and a heat-conducting element 512 (which consists of a cooling fin module 512a and a cooling plate 512b). The casing 5 has one radial air-guiding opening 52 on one side wall 5b thereof, with the radial air-guiding opening 52 communicating with the compartment 51. The compartment 51 is surrounded by a plurality of air-guiding lateral walls 53 to form a radial air channel 54 that communicates with the radial air-guiding opening 52.

The advection-type fan 6 has a base 61 that can be disposed in the radial air channel 54 by ways of adhesion, fastening or screwing. In this embodiment, the base 61 is disposed in the radial air channel 54 by way of adhesion. The base 61 has a shaft-coupling portion 611 to which an impeller 62 is rotatably connected. The base 61 further comprises a driving unit 63 that can drive the impeller 62 to rotate. The driving unit 63 may consist of components such as a coil, a circuit board and so on. One skilled in this art may readily appreciate that the driving unit 63 drives the impeller 62 to rotate based on alternating magnetic fields, so it is not described herein again.

The third embodiment differs from the first and second embodiments in that the plurality of air-guiding lateral walls 53 can form the radial air channel 54 for the casing 5. Therefore, the advection-type fan 6 does not need the frame 21, 41 as required by the advection-type fan 2, 4. This allows the base 61 and the impeller 62 to be directly disposed in the compartment 51 of the casing 5 for convenient assembly and simplified structural complexity. In this way, as shown in Fig. 7, when the heat-emitting source 511 is overheated during operation of the electronic device, the impeller 62 can draw the heat of the heat-emitting source 511 into the radial air channel 54. The drawn heat flows past the heat-conducting element 512 and is then expelled from the radial air channel 54 via the radial air-guiding opening 52. Alternatively, the impeller 62 can also draw air into the radial air channel 54 via the radial air-guiding opening 52, and then guides the air to the heat-emitting source 511 for cooling purpose. Furthermore, the cooling system of the third embodiment also allows the casing 5 to have a smaller thickness, thereby reducing the volume of the casing 5. Thus, the convenient manufacturing and assembly of the casing 5 are achieved and the structural complexity of the casing 5 is simplified.

In conclusion, the height of the compartment 11, 31 of the casing 1, 3 in the first and second embodiments can be designed in a smaller value fitted to the axial height (H) of the air-guiding lateral wall 211, 411. In addition, the height of the compartment 51 of the casing 5 in the third embodiment can be further reduced to a value fitted to the height of the impeller 62. In overall, the casing 1, 3, 5 of the invention can have a smaller height, thus reducing the volume thereof.

Although the invention has been described in detail with reference to its presently preferable embodiment, it will be understood by one of ordinary skill in the art that various modifications can be made without departing from the spirit and the scope of the invention, as set forth in the appended claims.

## Claims

1. A cooling system equipped with an advection-type fan, comprising:
a casing (1, 3) having a compartment (11, 31); and
an advection-type fan (2, 4);
wherein the cooling system is **characterized in that**:
the compartment (11, 31) of the casing (1, 3) receives a heat-emitting source (111, 311) or a heat-conducting element (112), the casing (1, 3) further comprises at least one radial air-guiding opening (12, 32) communicating with the compartment (11, 31);
the advection-type fan (2, 4) has a frame (21, 41) disposed in the compartment (11, 31), the frame (21, 41) has an air-guiding lateral wall (211, 411) defining a radial air channel (212, 412), the frame (21, 41) has a radial air inlet (213, 413) and a radial air outlet (214, 414), both the radial air inlet (213, 413) and the radial air outlet (214, 414) communicate with the radial air channel (212, 412), the radial air channel (212, 412) receives an impeller (22, 42) that causes air advection to dissipate the heat of the heat-emitting source (111, 311) or the heat-conducting element (112), and the frame (21, 41) has two sides in an axial direction of the impeller (22, 42) that are completely laid open.

2. The cooling system equipped with the advection-type fan as claimed in claim 1, **characterized in that** the at least one radial air-guiding opening (12, 32) is a single radial air-guiding opening (32), and one of the radial air inlet (413) and the radial air outlet (414) faces the heat-emitting source (311) or the heat-conducting element (112) while the other one faces the single radial air-guiding opening (32).

3. The cooling system equipped with the advection-type fan as claimed in claim 1, **characterized in that** the at least one radial air-guiding opening (12, 32) comprises two radial air-guiding openings (12), and the radial air inlet (213) and the radial air outlet (214) face the two radial air-guiding openings (12) of the casing (1) respectively.

4. The cooling system equipped with the advection-type fan as claimed in claim 1, **characterized in that** the casing (1, 3) further comprises a bottom plate (1a, 3a) and a cover plate (1c, 3c), the bottom plate (1a, 3a) has a plurality of side walls (1b, 3b) on a periphery thereof, the side walls (1b, 3b) are connected to the cover plate (1c, 3c), and the at least one radial air-guiding opening (12, 32) is arranged on the side walls (1b, 3b) of the casing (1, 3).

5. The cooling system equipped with the advection-type fan as claimed in claim 4, **characterized in that** the bottom plate (1a, 3a) and the cover plate (1c, 3c) jointly define the compartment (11, 31) of the casing (1, 3).

6. The cooling system equipped with the advection-type fan as claimed in claim 5, **characterized in that** the bottom plate (1a, 3a) and the cover plate (1c, 3c) are disposed in the axial direction of the impeller (22, 42) to cover the rotation range of the impeller (22, 42), thereby closing the radial air channel (212, 412) in the axial direction of the impeller (22, 42).

7. The cooling system equipped with the advection-type fan as claimed in claim 5, **characterized in that** the cover plate (1c, 3c) is disposed over the impeller (22, 42) to cover the rotation range of the impeller (22, 42), thereby closing the radial air channel (212, 412) in the axial direction of the impeller (22, 42).

8. The cooling system equipped with the advection-type fan as claimed in claim 4, **characterized in that** the bottom plate (1a, 3 a) is spaced from the cover plate (1c, 3c) by a distance (D), the air-guiding lateral wall (211, 411) has an axial height (H) in the axial direction of the impeller (22, 42), and the axial height (H) is equal to the distance (D).

9. The cooling system equipped with the advection-type fan as claimed in claim 4, **characterized in that** a sealing element (26, 46) is disposed between the air-guiding lateral wall (211, 411) and the bottom plate (1a, 3a), or between the air-guiding lateral wall (211, 411) and the cover plate (1c, 3c).

10. The cooling system equipped with the advection-type fan as claimed in claim 9, **characterized in that** the sealing element (26, 46) is disposed at one side of the air-guiding lateral wall (211, 411) that faces the bottom plate (1a, 3 a) or the cover plate (1c, 3c).

11. The cooling system equipped with the advection-type fan as claimed in claim 3, **characterized in that** the casing (1) further comprises a bottom plate (1a) and a cover plate (1c), the bottom plate (1a) has a plurality of side walls (1b) on a periphery thereof, the side walls (1b) are connected to the cover plate (1c), and the two radial air-guiding openings (12) are arranged on adjacent two of the plurality of side walls (1b) of the casing (1, 3).

12. The cooling system equipped with the advection-type fan as claimed in claim 1, **characterized in that** at least one fixing portion (13) is arranged between the two radial air-guiding openings (12, 32) for fixing the advection-type fan (2, 4).

13. The cooling system equipped with the advection-type fan as claimed in claim 12, **characterized in that** the at least one fixing portion (13) comprises two engaging grooves, and the air-guiding lateral wall (211, 411) of the frame (21, 41) has two engaged protrusions (25) respectively inserted into the two engaging grooves of the air-guiding lateral wall (211, 411).

14. A cooling system equipped with an advection-type fan, comprising:
a casing (5) having a compartment (51); and
an advection-type fan (6);
wherein the cooling system is **characterized in that**:
the compartment (51) of the casing (5) receives a heat-emitting source (511) or a heat-conducting element (512), the casing (5) further comprises a radial air-guiding opening (52) communicating with the compartment (51), and the compartment (51) forms a radial air channel (54) communicating with the radial air-guiding opening (52);
the advection-type fan (6) has a base (61) disposed in the radial air channel (54) and coupled with an impeller (62), the impeller (62) causes air advection to dissipate the heat of the heat-emitting source (511) or the heat-conducting element (512).

15. The cooling system equipped with the advection-type fan as claimed in claim 14, **characterized in that** the compartment (51) has a plurality of air-guiding lateral walls (53) that form the radial air channel (54).

16. The cooling system equipped with the advection-type fan as claimed in claim 14, **characterized in that** the casing (5) further comprises a bottom plate (5a) and a cover plate (5c), the bottom plate (5a) has a plurality of side walls (5b) on a periphery thereof, the side walls (5b) are connected to the cover plate (5c), and the radial air-guiding opening (52) is arranged on one of the side walls (5b) of the casing (5).

17. The cooling system equipped with the advection-type fan as claimed in claim 16, **characterized in that** the bottom plate (5a) and the cover plate (5c) jointly define the compartment (51) of the casing (5).

18. The cooling system equipped with the advection-type fan as claimed in claim 17, **characterized in that** the bottom plate (5a) and the cover plate (5c) are disposed in the axial direction of the impeller (62) to cover the rotation range of the impeller (62), thereby closing the radial air channel (54) in the axial direction of the impeller (62).

19. The cooling system equipped with the advection-type fan as claimed in claim 17, **characterized in that** the cover plate (5c) is disposed over the impeller (62) to cover the rotation range of the impeller (62), thereby closing the radial air channel (54) in the axial direction of the impeller (62).
